# EUROPEAN PATENT APPLICATION

(11) **EP 4 307 114 A1**
(43) Date of publication of application: **17.01.2024**
(21) Application number: 22306061.7
(22) Date of filing: 13.07.2022
(51) Int. Cl.: G06F 9/50

(54) **SYSTEMS AND METHODS FOR DYNAMIC COMPUTING RESOURCE ALLOCATION FOR MACHINE LEARNING ALGORITHMS**

(71) Applicant: Gladia, 75001 Paris (FR)
(72) Inventor: BOULANT, Olivier, 75001 Paris (FR); QUEGUINER, Jean-Louis, 75001 Paris (FR)
(74) Representative: BCF Global

(57) **Abstract**

Methods and systems for generating an orchestrating model configured to orchestrate a memory allocation of a machine learning algorithm (MLA)-dedicated memory, a computing unit being communicably connected to a MLA database configured for storing a plurality of MLAs, the method comprising receiving one or more execution queries to execute one or more MLAs, causing the computing unit to execute the one or more MLAs based on the one or more execution queries, generating MLA forecast data, generating an indication of a performance indicator for each one of the one or more MLAs, the indication having been computed based on a comparison of the MLA forecast data of the MLA and execution queries for the MLA and/or current execution of the one or more MLAs, and training the orchestrating model based on the indication of the performance indicator.

## Description

### FIELD OF THE TECHNOLOGY

The present technology relates to systems and methods for computer memory allocation. In particular, a system and methods for dynamic memory allocation for machine learning algorithms are disclosed.

### BACKGROUND

Machine Learning algorithms (MLAs) have recently gained traction in a wide range of applications. Many use cases of MLAs require increased processing resources that may be available to users by Artificial Intelligence (AI) service providers. For example, some AI service providers let users use dedicated computing resources by providing Virtual Machines (VM) that emulate a computer architecture suitable for executing a desired trained MLA by the user.

However, before an MLA can be executed by a user, said MLA has to be deployed in a memory (e.g. a cache), which leads to memory allocation issues. Indeed, the memory of a Graphical Processing Unit (GPU) may only be split to a certain extent due to safety and privacy concerns. Indeed, a same computing node (unit of computing resources) may not be used for two distinct MLA executions for two distinct users. Besides, deployment of a MLA in the memory before execution of the MLA (or before "inference time") may be a time-consuming process due to large amount of data that has to be loaded in the memory to enable the MLA to be further executed. As a result, the user usually experiences a high waiting time, or an "execution latency", before being able to execute the desired MLA.

Therefore, there is a desire for a system that dynamically allocates computing resources for MLAs execution to reduce execution latency of the MLAs.

### SUMMARY

Embodiments of the present technology have been developed based on developers' appreciation of shortcomings associated with the prior art.

In a first broad aspect of the present technology, there is provided a method for generating an orchestrating model configured to orchestrate a memory allocation of a machine learning algorithm (MLA)-dedicated memory communicably connected to a computing unit, the computing unit being configured to execute one or more MLAs deployed in the MLA-dedicated memory, the computing unit being communicably connected to an MLA database configured for storing a plurality of MLAs, the method comprising: receiving one or more execution queries to execute the one or more MLAs; causing the computing unit to execute the one or more MLAs based on the one or more execution queries; generating MLA forecast data based on the one or more execution queries and/or execution of the one or more MLAs at a first moment in time; generating an indication of a performance indicator for each one of the one or more MLAs, the indication having been computed based on a comparison of the MLA forecast data of the MLA and execution queries for the MLA and/or current execution of the one or more MLAs at a second moment in time, the second moment in time being later than the first moment in time; and updating the orchestrating model based on the indication of the performance indicator.

In some implementations of the present technology, the method further comprises, subsequent to causing the computing unit to execute a given MLA: detecting an end of the execution of the given MLA.

In some implementations of the present technology, the method further comprises, subsequent to detecting the end of the execution of the given MLA: discarding the given MLA from the MLA-dedicated memory.

In some implementations of the present technology, the given MLA is associated with an MLA category in the MLA database, the MLA category being indicative of discarding instructions to be executed to discard the given MLA from the MLA-dedicated memory.

In some implementations of the present technology, the discarding instructions comprise indication of a pre-determined time duration, the method further comprising, subsequent to detecting the end of the execution of the given MLA: triggering a counter indicative of an amount of time that has passed since the end of the execution of the given MLA has been detected, wherein discarding, the given MLA from the MLA-dedicated memory comprises: in response to the counter reaching the pre-determined time value, discarding the given MLA from the MLA-dedicated memory.

In some implementations of the present technology, the given MLA is a first MLA, the MLA category being further indicative of a priority level of the first MLA, wherein discarding the given MLA from the MLA-dedicated memory is made in response to determining that a second MLA is to be deployed in the MLA-dedicated memory, the second MLA having a priority level than a priority level of the first MLA.

In some implementations of the present technology, a first MLA category is indicative of instructions comprising indication of a first pre-determined time duration, the first pre-determined duration being strictly positive; and a second MLA category is indicative of instructions comprising indication of a second pre-determined time duration, the second pre-determined duration being zero.

In some implementations of the present technology, each MLA of the MLA database is associated with an MLA category and a level priority, the MLA category being indicative of discarding instructions to be executed subsequent to an execution thereof; a first MLA category is associated with discarding instructions which, upon being executed, cause an MLA of the first MLA category to be maintained in the MLA-dedicated memory; a second MLA category is associated with discarding instructions which, upon being executed, cause an MLA of the second MLA category to be discarded from the MLA-dedicated memory once an execution thereof has ended; a third MLA category is associated with discarding instructions which, upon being executed, cause: a timer to be triggered once an execution of an MLA of the third MLA category has ended, the timer having a pre-determined value for each MLA of the third category, the timer being reset in response to the MLA being further executed and further triggered once the new execution has ended, and the MLA of the third MLA category to be discarded from the MLA-dedicated memory once the timer has reached the pre-determined value and in response to an MLA having a higher priority level is to be deployed in the MLA-dedicated memory; and a fourth MLA category is associated with discarding instructions which, upon being executed, cause an MLA of the fourth MLA category to be discarded from the MLA-dedicated memory in response to an MLA having a higher priority level is to be deployed in the MLA-dedicated memory.

In some implementations of the present technology, connection between the one or more user devices and the controller is operated over an Application Programming Interface (API) gateway.

In some implementations of the present technology, the method further comprises, prior to receiving the one or more execution queries to deploy one or more MLAs from the MLA database onto the MLA-dedicated memory: providing, to a user, a choice of MLAs to execute of the one of the one or more user devices over the API gateway.

In some implementations of the present technology, the one or more MLA forecast data are based on a number of the one or more execution queries.

In some implementations of the present technology, causing the computing unit to execute the one or more MLAs comprises: if determination is made that one of the one or more MLAs is not deployed in the MLA-dedicated memory, deploying the one of the one or more MLAs in the MLA-dedicated memory.

In some implementations of the present technology, the method further comprises: partitioning computer resources of the computing unit into a plurality of resource pools; extracting, from the one or more execution queries, information about a number of resource pools required to execute the one or more corresponding MLAs.

In some implementations of the present technology, an MLA forecast data associated with a given MLA is based on an evolution of the number of resource pools required to execute the given MLA according to the one or more execution queries.

In some implementations of the present technology, causing the computing unit to execute the one or more MLAs based on the one or more execution queries comprises: determining an execution runtime of each of the one or more MLAs, wherein MLA forecast data associated with a given MLA is based on the execution runtime of the given MLA.

In some implementations of the present technology, receiving one or more execution queries to execute the one or more MLAs comprises: determining, for each MLA, a temporal indication of a desired execution of the MLA, wherein MLA forecast data associated with a given MLA is based on the determined temporal indication.

In some implementations of the present technology, the method further comprises: executing the trained orchestrating model, the trained orchestrating model being configured to, in use, deploy MLAs from the MLA database onto the MLA-dedicated memory based on the MLA forecast data corresponding to said MLAs.

In some implementations of the present technology, the method is executed by a controller communicably connected to the computing unit, the MLA-dedicated memory and the MLA database.

In some implementations of the present technology, each of the one or more execution queries comprises: information about a selection of at least one of the one or more MLAs; input data for the at least one of the one or more MLAs; and execution query metadata comprising information about computing resources required to execute the at least one of the one or more MLAs, said information being determined based on the input data.

In a second broad aspect of the present technology, there is provided a method of orchestrating a memory allocation of a machine learning algorithm (MLA)-dedicated memory communicably connected to a computing unit, the computing unit being configured to execute MLAs deployed in the MLA-dedicated memory, the MLA-dedicated memory being communicably connected to a MLA database configured for storing a plurality of MLAs, the method comprising: determining, for each MLA of the MLA database, an MLA forecast data, the MLA forecast data being indicative of an expected usage, by the computing unit, of the corresponding MLA; deploying a given MLA in the MLA-dedicated memory based on the MLA forecast data of the given MLA prior to receiving one or more execution queries; and executing the one or more MLAs of the deployed MLAs.

In some implementations of the present technology, the method is executed by a controller communicably connected to the computing unit, the MLA-dedicated memory and the MLA database.

In some implementations of the present technology, the determined MLA forecast data is used to generate an orchestrating model in accordance with the method for generating an orchestrating model configured to orchestrate a memory allocation of a MLA-dedicated memory communicably connected to a computing unit.

In some implementations of the present technology, the deploying a given MLA in the MLA-dedicated memory is made based on the orchestrating model.

In some implementations of the present technology, upon executing the one or more MLAs of the deployed MLAs, the method further comprises: generating further MLA forecast data, the further generated MLA forecast data being relied upon to further train the orchestrating model.

In some implementations of the present technology, determining, by the controller and for each MLA of the MLA database, an MLA forecast data comprises: generating, by controller, MLA forecast data based on one or more execution queries received by the controller from one or more user devices communicably connected to the controller, the MLA forecast data being consolidated to generate the MLA forecast data.

In some implementations of the present technology, each MLA is associated with an MLA category, the MLA category being indicative of instructions to be executed by the controller to discard the given MLA.

In some implementations of the present technology, the instructions comprise indication of a pre-determined time duration, the method further comprising: detecting an end of the execution of the given MLA: triggering, by the controller, a counter indicative of an amount of time that has passed since the end of the execution of the given MLA has been detected; and in response to the counter reaching the pre-determined time value, discarding, by the controller, the given MLA from the MLA-dedicated memory.

In some implementations of the present technology, the given MLA is a first MLA, the MLA category being further indicative of a priority level of the first MLA; and discarding, by the controller, the given MLA from the MLA-dedicated memory is made in response to determining, by the controller, that a second MLA is to be deployed in the MLA-dedicated memory, the second MLA having a priority level than a priority level of the first MLA.

In some implementations of the present technology, a first MLA category is indicative of instructions comprising indication of a first pre-determined time duration, the first pre-determined duration being strictly positive; and a second MLA category is indicative of instructions comprising indication of a second pre-determined time duration, the second pre-determined duration being zero.

In some implementations of the present technology, each MLA of the MLA database is associated with an MLA category and a level priority, the MLA category being indicative of discarding instructions to be executed subsequent to an execution thereof; a first MLA category is associated with discarding instructions which, upon being executed, cause an MLA of the first MLA category to be maintained in the MLA-dedicated memory; a second MLA category is associated with discarding instructions which, upon being executed, cause an MLA of the second MLA category to be discarded from the MLA-dedicated memory once an execution thereof has ended; a third MLA category is associated with discarding instructions which, upon being executed, cause: a timer to be triggered once an execution of an MLA of the third MLA category has ended, the timer having a pre-determined value for each MLA of the third category, the timer being reset in response to the MLA being further executed and further triggered once the new execution has ended, and the MLA of the third MLA category to be discarded from the MLA-dedicated memory once the timer has reached the pre-determined value and in response to an MLA having a higher priority level is to be deployed in the MLA-dedicated memory; and a fourth MLA category is associated with discarding instructions which, upon being executed, cause an MLA of the fourth MLA category to be discarded from the MLA-dedicated memory in response to an MLA having a higher priority level is to be deployed in the MLA-dedicated memory.

In a third broad aspect of the present technology, there is provided a system for orchestrating a memory allocation of a machine learning algorithm (MLA)-dedicated memory communicably connected to a processor, the processor being configured to execute MLAs deployed in the MLA-dedicated memory, the system comprising a controller and a memory storing a plurality of executable instructions which, when executed by the controller, cause the system to perform the method for generating the orchestrating model configured to orchestrate the memory allocation of the MLA-dedicated memory.

In a fourth broad aspect of the present technology, there is provided a non-transitory computer-readable medium comprising computer-readable instructions that, upon being executed by a system, cause the system to perform the method for generating the orchestrating model configured to orchestrate the memory allocation of the machine learning algorithm (MLA)-dedicated memory communicably connected to the computing unit.

In a fifth broad aspect of the present technology, there is provided a system for orchestrating a memory allocation of a machine learning algorithm (MLA)-dedicated memory communicably connected to a processor, the processor being configured to execute MLAs deployed in the MLA-dedicated memory, the system comprising a controller and a memory storing a plurality of executable instructions which, when executed by the controller, cause the system to perform the method of orchestrating the memory allocation of the MLA-dedicated memory.

In a sixth broad aspect of the present technology, there is provided a non-transitory computer-readable medium comprising computer-readable instructions that, upon being executed by a system, cause the system to perform the method of orchestrating the memory allocation of the machine learning algorithm (MLA)-dedicated memory communicably connected to the computing unit.

In the context of the present specification, a "server" is a computer program that is running on appropriate hardware and is capable of receiving requests (e.g., from client devices) over a network, and carrying out those requests, or causing those requests to be carried out. The hardware may be one physical computer or one physical computer system, but neither is required to be the case with respect to the present technology. In the present context, the use of the expression a "server" is not intended to mean that every task (e.g., received instructions or requests) or any particular task will have been received, carried out, or caused to be carried out, by the same server (i.e., the same software and/or hardware); it is intended to mean that any number of software elements or hardware devices may be involved in receiving/sending, carrying out or causing to be carried out any task or request, or the consequences of any task or request; and all of this software and hardware may be one server or multiple servers, both of which are included within the expression "at least one server".

In the context of the present specification, "user device" is any computer hardware that is capable of running software appropriate to the relevant task at hand. Thus, some (non-limiting) examples of user devices include personal computers (desktops, laptops, netbooks, etc.), smartphones, and tablets, as well as network equipment such as routers, switches, and gateways. It should be noted that a device acting as a user device in the present context is not precluded from acting as a server to other user devices. The use of the expression "a user device" does not preclude multiple user devices being used in receiving/sending, carrying out or causing to be carried out any task or request, or the consequences of any task or request, or steps of any method described herein.

In the context of the present specification, a "database" is any structured collection of data, irrespective of its particular structure, the database management software, or the computer hardware on which the data is stored, implemented or otherwise rendered available for use. A database may reside on the same hardware as the process that stores or makes use of the information stored in the database or it may reside on separate hardware, such as a dedicated server or plurality of servers.

In the context of the present specification, the expression "information" includes information of any nature or kind whatsoever capable of being stored in a database. Thus information includes, but is not limited to audiovisual works (images, movies, sound records, presentations etc.), data (location data, numerical data, etc.), text (opinions, comments, questions, messages, etc.), documents, spreadsheets, lists of words, etc.

In the context of the present specification, the expression "component" is meant to include software (appropriate to a particular hardware context) that is both necessary and sufficient to achieve the specific function(s) being referenced.

In the context of the present specification, the expression "computer usable information storage medium" is intended to include media of any nature and kind whatsoever, including RAM, ROM, disks (CD-ROMs, DVDs, floppy disks, hard drivers, etc.), USB keys, solid state-drives, tape drives, etc.

In the context of the present specification, unless expressly provided otherwise, an "indication" of an information element may be the information element itself or a pointer, reference, link, or other indirect mechanism enabling the recipient of the indication to locate a network, memory, database, or other computer-readable medium location from which the information element may be retrieved. As one skilled in the art would recognize, the degree of precision required in such an indication depends on the extent of any prior understanding about the interpretation to be given to information being exchanged as between the sender and the recipient of the indication. For example, if it is understood prior to a communication between a sender and a recipient that an indication of an information element will take the form of a database key for an entry in a particular table of a predetermined database containing the information element, then the sending of the database key is all that is required to effectively convey the information element to the recipient, even though the information element itself was not transmitted as between the sender and the recipient of the indication.

In the context of the present specification, the words "first", "second", "third", etc. have been used as adjectives only for the purpose of allowing for distinction between the nouns that they modify from one another, and not for the purpose of describing any particular relationship between those nouns. Thus, for example, it should be understood that, the use of the terms "first server" and "third server" is not intended to imply any particular order, type, chronology, hierarchy or ranking (for example) of/between the server, nor is their use (by itself) intended imply that any "second server" must necessarily exist in any given situation. Further, as is discussed herein in other contexts, reference to a "first" element and a "second" element does not preclude the two elements from being the same actual real-world element. Thus, for example, in some instances, a "first" server and a "second" server may be the same software and/or hardware, in other cases they may be different software and/or hardware.

Implementations of the present technology each have at least one of the above-mentioned objects and/or aspects, but do not necessarily have all of them. It should be understood that some aspects of the present technology that have resulted from attempting to attain the above-mentioned object may not satisfy this object and/or may satisfy other objects not specifically recited herein.

Additional and/or alternative features, aspects and advantages of implementations of the present technology will become apparent from the following description, the accompanying drawings and the appended claims.

### BRIEF DESCRIPTION OF THE DRAWINGS

For a better understanding of the present technology, as well as other aspects and further features thereof, reference is made to the following description which is to be used in conjunction with the accompanying drawings, where:
FIG. 1 is a schematic representation of a dynamic MLA platform in accordance with non-limiting embodiments of the present technology;
FIG. 2 is a schematic representation of a user device configured for communicating with a data management system in accordance with an embodiment of the present technology;
FIG. 3 is a schematic representation of a generation of orchestrating models in accordance with non-limiting embodiments of the present technology;
FIG. 4 is a schematic representation of a temporal evolution of computer resources used and forecasted for execution of a given MLA within the dynamic MLA platform of FIG. 1 in accordance with non-limiting embodiments of the present technology; and
FIG. 5 illustrates a temporal evolution of computing resources used and forecasted for execution of a first MLA in an MLA-dedicated memory of the dynamic MLA platform of FIG. 1, and a temporal evolution of computing resources used and forecasted for execution of a second MLA in the MLA-dedicated memory, in accordance with non-limiting embodiments of the present technology.
FIG. 6 is a block diagram representative of four configurations of the MLA-dedicated memory in different use case scenarios;
FIG. 7 is a flow diagram showing operations of a method for generating an orchestrating model configured to orchestrate a memory allocation of the MLA-dedicated memory communicably connected to a computing unit in accordance with some embodiments of the present technology;
FIG. 8 is a flow diagram showing operations of a method for orchestrating a memory allocation of the MLA-dedicated memory communicably connected to a computing unit in accordance with some embodiments of the present technology; and
FIG. 9 is block diagram of a controller in accordance with an embodiment of the present technology.

It should also be noted that, unless otherwise explicitly specified herein, the drawings are not to scale.

### DETAILED DESCRIPTION

The examples and conditional language recited herein are principally intended to aid the reader in understanding the principles of the present technology and not to limit its scope to such specifically recited examples and conditions. It will be appreciated that those skilled in the art may devise various arrangements that, although not explicitly described or shown herein, nonetheless embody the principles of the present technology.

Furthermore, as an aid to understanding, the following description may describe relatively simplified implementations of the present technology. As persons skilled in the art would understand, various implementations of the present technology may be of a greater complexity.

In some cases, what are believed to be helpful examples of modifications to the present technology may also be set forth. This is done merely as an aid to understanding, and, again, not to define the scope or set forth the bounds of the present technology. These modifications are not an exhaustive list, and a person skilled in the art may make other modifications while nonetheless remaining within the scope of the present technology. Further, where no examples of modifications have been set forth, it should not be interpreted that no modifications are possible and/or that what is described is the sole manner of implementing that element of the present technology.

Moreover, all statements herein reciting principles, aspects, and implementations of the present technology, as well as specific examples thereof, are intended to encompass both structural and functional equivalents thereof, whether they are currently known or developed in the future. Thus, for example, it will be appreciated by those skilled in the art that any block diagram herein represents conceptual views of illustrative circuitry embodying the principles of the present technology. Similarly, it will be appreciated that any flowcharts, flow diagrams, state transition diagrams, pseudo-code, and the like represent various processes that may be substantially represented in non-transitory computer-readable media and so executed by a computer or processor, whether or not such computer or processor is explicitly shown.

The functions of the various elements shown in the figures, including any functional block labeled as a "processor" or "processing unit", may be provided through the use of dedicated hardware as well as hardware capable of executing software in association with appropriate software. When provided by a processor, the functions may be provided by a single dedicated processor, by a single shared processor, or by a plurality of individual processors, some of which may be shared. In some embodiments of the present technology, the processor may be a general-purpose processor, such as a central processing unit (CPU) or a processor dedicated to a specific purpose, such as a digital signal processor (DSP). Moreover, explicit use of the term a "processor" should not be construed to refer exclusively to hardware capable of executing software, and may implicitly include, without limitation, application specific integrated circuit (ASIC), field programmable gate array (FPGA), read-only memory (ROM) for storing software, random access memory (RAM), and non-volatile storage. Other hardware, conventional and/or custom, may also be included.

Software modules, or simply modules which are implied to be software, may be represented herein as any combination of flowchart elements or other elements indicating performance of process steps and/or textual description. Such modules may be executed by hardware that is expressly or implicitly shown. Moreover, it should be understood that module may include for example, but without being limitative, computer program logic, computer program instructions, software, stack, firmware, hardware circuitry or a combination thereof which provides the required capabilities.

With these fundamentals in place, we will now consider some non-limiting examples to illustrate various implementations of aspects of the present technology.

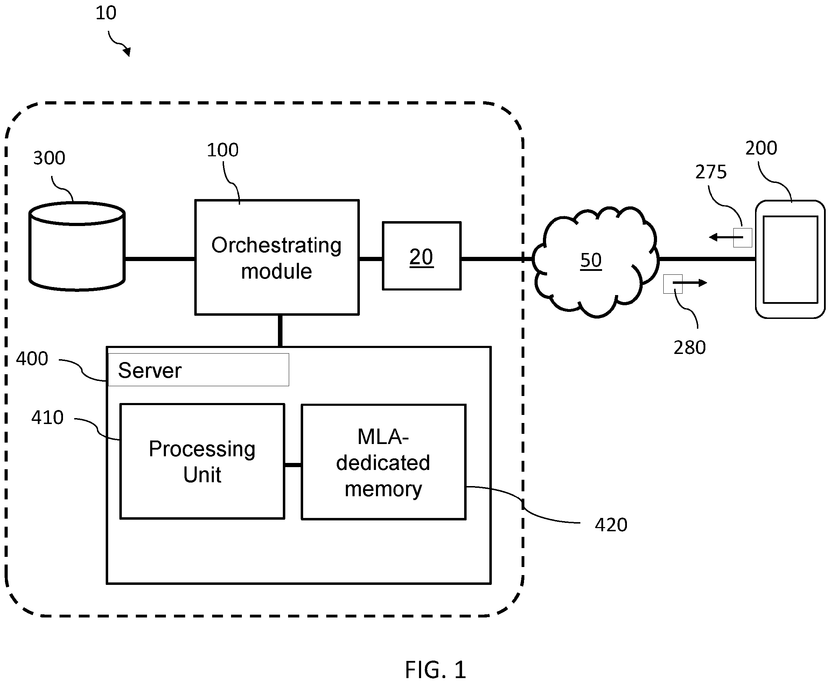

Referring to FIG. 1, there is shown a schematic diagram of a system 10, the system 10 being suitable for implementing non-limiting embodiments of the present technology. It is to be expressly understood that the system 10 as depicted is merely an illustrative implementation of the present technology. Thus, the description thereof that follows is intended to be only a description of illustrative examples of the present technology. This description is not intended to define the scope or set forth the bounds of the present technology. In some cases, what is believed to be helpful examples of modifications to the system 10 may also be set forth below. This is done merely as an aid to understanding, and, again, not to define the scope or set forth the bounds of the present technology. These modifications are not an exhaustive list, and, as a person skilled in the art would understand, other modifications are likely possible. Further, where this has not been done (i.e., where no examples of modifications have been set forth), it should not be interpreted that no modifications are possible and/or that what is described is the sole manner of implementing that element of the present technology. As a person skilled in the art would understand, this is likely not the case. In addition, it is to be understood that the system 10 may provide in certain instances simple implementations of the present technology, and that where such is the case they have been presented in this manner as an aid to understanding. As persons skilled in the art would understand, various implementations of the present technology may be of a greater complexity.

Generally speaking, the system 10 provides dynamically-allocated computing resources to an electronic device 200 for MLA execution. As such, the system 10 may be referred to as a dynamic MLA platform 10. As will be described in greater details herein after, the electronic device may be associated with a user desiring to use the dynamic MLA platform 10 to execute one or more MLAs thereon and with input data transmitted from the user device 200 and retrieve an MLA output from the dynamic MLA platform 10 onto the user device 200. Therefore, in at least some embodiments of the present technology, the dynamic MLA platform 10 may be a "commercially-oriented" dynamic MLA platform 10. Broadly speaking, a given commercially-oriented dynamic MLA platform 10 may be of use to users that desire to use computing resources of the dynamic MLA platform 10 to execute one or more MLAs and retrieve one or more outputs therefrom. For example, the users may seek to execute an MLA and transmit input data to the dynamic MLA platform 10, select an MLA to be executed on the input data, and retrieve an output of the MLA. Hence, users of such a system may be provided with high-performance computing capabilities for executing MLAs with low execution latency.

With reference to FIG. 1, the dynamic MLA platform 10 comprises one or more computing units 400 (represented as one computing unit 400 for simplicity) for executing MLAs, an MLA database 300 storing a plurality of MLAs, and an orchestrating module 100. Broadly speaking, the MLA database 300 stores information about MLAs (e.g. Open Neuronal Network Exchange (ONNX) files) that may be retrieved by the orchestrating module 100. The MLAs stored in the MLA database 300 may be, for example and without limitations, forecasting (e.g. weather forecasting, traffic forecasting) algorithms, image recognition algorithms and natural language processing algorithms (e.g. textual and/or speech recognition and translation). At least some of the MLAs of the MLA database 300 may be already trained, and at least some MLAs of the MLA database 300 may be untrained or partially trained.

Non limitative examples of MLAs of the MLA database 300 may include non-linear algorithm, linear regression, logistic regression, decision tree, support vector machine, naive bayes, K-nearest neighbors, K-means, random forest, dimensionality reduction, neural network, gradient boosting, adaboost, lasso, elastic net, ridge, bayesian ridge, Automatic Relevance Determination (ARD) regression, Stochastic Gradient Descent (SGD) regressor, passive aggressive regressor, k-neighbors regressor and/or Support Vector Regression (SVR). Other MLAs may also be envisioned without departing from the scope of the present technology.

Based on information about a given MLA retrieved by the orchestrating module 100, the orchestrating module 100 further deploys the given MLA in the computing unit 400 such that the given MLA may be executed. The orchestrating module 100 may also cause execution of MLAs that are already deployed in the computing unit 400. More specifically, the computing unit 400 comprises an MLA-dedicated memory 420 onto which the MLAs are deployed, and a processing unit 410 executing the MLAs deployed in the MLA-dedicated memory 420. It should be noted that the MLA-dedicated memory 420 may be used for additional functions than deployment of MLAs. The wording "MLA-dedicated" is merely used to distinguish the memory 420 from other memories that are described in the present disclosure. The MLA-dedicated memory 420 may be, for example and without limitations, a Random Access Memory (RAM), a Video Random Access Memory (VRAM), a Window Random Access Memory (WRAM), a Multibank Dynamic Random Access Memory (MDRAM), a Double Data Rate (DDR) memory, a Graphics Double Data Rate (GDDR) memory, a High Bandwidth Memory (HBM), a Fast-Cycle Random-Access Memory (FCRAM) or any other suitable device suitable.

### User device

As shown on FIG. 1, the dynamic MLA platform 10 is communicably connected with one or more user devices 200 (represented as one user device 200 for simplicity) over a communication network 50. The user device 200 may be associated with a respective user. As such, the user device 200 can sometimes be referred to as a "client device" or "client electronic device". It should be noted that the fact that the user device 200 is associated with a user does not need to suggest or imply any mode of operation - such as a need to log in, a need to be registered, or the like. It should be appreciated that in other embodiments, the dynamic MLA platform 10 can be communicably connected to additional users and user devices in parallel.

The implementation of the user device 200 is not particularly limited, but as an example, the user device 200 may be implemented as a personal computer (desktops, laptops, netbooks, etc.), a wireless communication device (such as a smartphone, a cell phone, a tablet and the like), as well as network equipment (such as routers, switches, and gateways). The user device 200 comprises hardware and/or software and/or firmware (or a combination thereof), as is known in the art, to communicate with the dynamic MLA platform 10. Generally speaking, the user device 200 may transmit, for example, an MLA execution query 275 for using computer resources of the dynamic MLA platform 10. In at least some embodiments, the MLA execution query 275 includes:
- information about a selection of one or more desired MLAs of the MLA database 300 to be executed; and
- input data to be used for execution of the one or more desired MLAs.

In some embodiments, the MLA execution query 275 further includes information about an identification of the user transmitting the MLA execution query 275, a desired order of executions the desired MLA in case there are two or more desired MLAs. The orchestrating module 100 may generate, for each user or user device 200, data comprising information about a frequency of reception of MLA execution queries. In some embodiments, the input data transmitted by the user device 200 may be used for further training of the one or more MLAs. In some embodiments, the input data is turned, by the dynamic MLA platform 10, into data usable by the selected one or more desired MLA. This operation may be referred to as "pre-processing". Without being limitative, pre-processing may comprise feature extraction methods, feature selection methods and/or cleaning data methods. In some embodiments, the pre-processing may comprise executing principal component analysis (PCA) which may be summarized as a linear dimensionality reduction using singular value decomposition of a dataset to project the dataset to a lower dimensional space. In some embodiments, the input data may include one or more datasets (e.g. a dataset may be a file or a combination of files) and the pre-processing may also comprise a combine features method allowing creation of a new dataset from two other datasets. In some embodiments, this combination may create a transformed dataset which has potentially gained more information from the two different pre-processing methods. Other pre-processing approaches may also comprise, for example, and without being limitative, Binarizer, FeatureAgglomeration, MaxAbsScaler, MinMaxScaler, Normalizer, PCA, RBFSampler, RobustScaler, StandardScaler, SelectFwe, SelectPercentile, VarianceThreshold.

In some embodiments, the information about a selection of a given MLA may comprise parameters (e.g., parameters of a classifier, regressor, etc.) which may be configured prior to the learning process to which the given MLA is subjected to. In some embodiments, the parameters may be polynomial features allowing better ML model fitting with a dataset. The polynomial features may be implemented as a feature matrix consisting of all polynomial combinations of features with a degree less than or equal to a specified degree. The configuration of parameters of the given MLA may be executed before, during and/or after the training of the given MLA on a given input data or dataset thereof. In some embodiments, the trained MLA defining a corresponding ML model may be further optimized upon being used, for example, by further refining one or more of the parameters.

The user device 200 may also receive one or more outputs 280 resulting from the execution of the one or more desired MLAs. It should be noted that the one or more desired MLAs have been executed within the dynamic MLA platform 10, such that no computing resource of the user device 200 has been used to generate the outputs. As such, the user device 200 of FIG. 1 may include any type of computing device that enables users to transmit and receive information from the dynamic MLA platform 10.

In this embodiment, communication between the user device 200 rely on a communication application 20 may be, for example and without limitations, an Application Programming Interface (API), a website, a web application or an application. In this embodiment, the communication application 20 may comprise information about an identification of the user device 200 such that the dynamic MLA platform 10 may distinguish between the different user device communicably connected thereto. It should be understood that, upon sending an MLA execution query 275 or any other form of signal to the dynamic MLA platform 10, a given user device 200 is configured to indicate said identification in the transmitted signal such that the dynamic MLA platform 10 transmits information in response back to the given user device 200.

In this embodiment, the communication application 20 provides the user with a choice of MLAs that may be executed by the dynamic MLA platform 10. For example, the communication application may cause the user device 200 to display a catalogue of the MLAs stored in the MLA database 300 to a corresponding user.

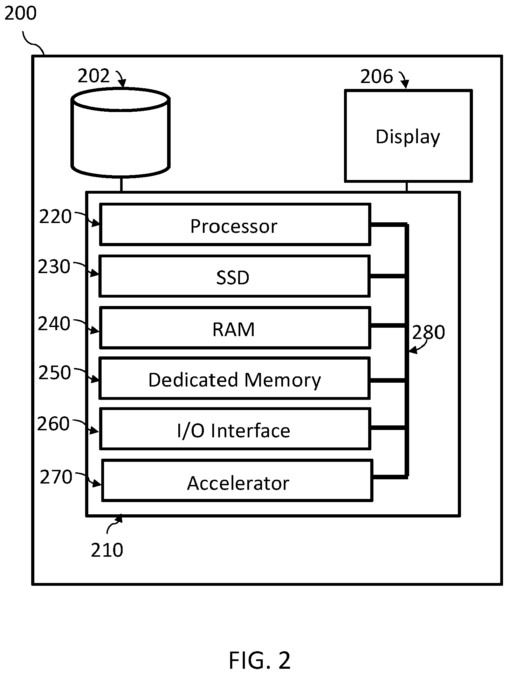

FIG. 2 is a schematic representation of the user device 200 in accordance with an embodiment of the present technology. The user device 200 comprises a computing unit 210. In some embodiments, the computing unit 210 may be implemented by any of a conventional personal computer, a controller, and/or an electronic device (e.g., a server, a controller unit, a control device, a monitoring device etc.) and/or any combination thereof appropriate to the relevant task at hand. In some embodiments, the computing unit 210 comprises various hardware components including one or more single or multi-core processors collectively represented by a processor 220, a solid-state drive 230, a RAM 240, a dedicated memory 250 and an input/output interface 260. The computing unit 210 may be a generic computer system.

In some other embodiments, the computing unit 210 may be an "off the shelf' generic computer system. In some embodiments, the computing unit 210 may also be distributed amongst multiple systems. The computing unit 210 may also be specifically dedicated to the implementation of the present technology. As a person in the art of the present technology may appreciate, multiple variations as to how the computing unit 210 is implemented may be envisioned without departing from the scope of the present technology.

Communication between the various components of the computing unit 210 may be enabled by one or more internal and/or external buses 280 (e.g. a PCI bus, universal serial bus, IEEE 1394 "Firewire" bus, SCSI bus, Serial-ATA bus, ARINC bus, etc.), to which the various hardware components are electronically coupled.

The input/output interface 260 may provide networking capabilities such as wired or wireless access. As an example, the input/output interface 260 may comprise a networking interface such as, but not limited to, one or more network ports, one or more network sockets, one or more network interface controllers and the like. Multiple examples of how the networking interface may be implemented will become apparent to the person skilled in the art of the present technology. For example, but without being limitative, the networking interface may implement specific physical layer and data link layer standard such as Ethernet, Fibre Channel, Wi-Fi or Token Ring. The specific physical layer and the data link layer may provide a base for a full network protocol stack, allowing communication among small groups of computers on the same local area network (LAN) and large-scale network communications through routable protocols, such as Internet Protocol (IP).

According to implementations of the present technology, the solid-state drive 230 stores program instructions suitable for being loaded into the RAM 240 and executed by the processor 220. Although illustrated as a solid-state drive 230, any type of memory may be used in place of the solid-state drive 230, such as a hard disk, optical disk, and/or removable storage media.

The processor 220 may be a general-purpose processor, such as a central processing unit (CPU) or a processor dedicated to a specific purpose, such as a digital signal processor (DSP). In some embodiments, the processor 220 may also rely on an accelerator 270 dedicated to certain given tasks. In some embodiments, the processor 220 or the accelerator 270 may be implemented as one or more field programmable gate arrays (FPGAs). Moreover, explicit use of the term "processor", should not be construed to refer exclusively to hardware capable of executing software, and may implicitly include, without limitation, application specific integrated circuit (ASIC), read-only memory (ROM) for storing software, RAM, and non-volatile storage. Other hardware, conventional and/or custom, may also be included.

Further, the user device 200 may include a screen or display 206 capable of rendering an interface of the communication application 20 and/or the one or more outputs 280. In some embodiments, display 206 may comprise and/or be housed with a touchscreen to permit users to input data via some combination of virtual keyboards, icons, menus, or other Graphical User Interfaces (GUIs). In some embodiments, display 206 may be implemented using a Liquid Crystal Display (LCD) display or a Light Emitting Diode (LED) display, such as an Organic LED (OLED) display. The device may be, for example and without being limitative, a handheld computer, a personal digital assistant, a cellular phone, a network device, a smartphone, a navigation device, an e-mail device, a game console, or a combination of two or more of these data processing devices or other data processing devices.

The user device 200 may comprise a memory 202 communicably connected to the computing unit 210 for storing the one or more outputs 280 for example. The memory 202 may be embedded in the user device 200 as in the illustrated embodiment of FIG. 2 or located in an external physical location. The computing unit 210 may be configured to access a content of the memory 202 via a network (not shown) such as a Local Area Network (LAN) and/or a wireless connexion such as a Wireless Local Area Network (WLAN).

The user device 200 may also include a power system (not depicted) for powering the various components. The power system may include a power management system, one or more power sources (e.g., battery, alternating current (AC)), a recharging system, a power failure detection circuit, a power converter or inverter and any other components associated with the generation, management and distribution of power in mobile or non-mobile devices.

### Communication network

Referring back to FIG. 1, the user device 200 and the dynamic MLA platform 10 are communicatively coupled one to another over the communication network 50 via any wired or wireless communication link including, for example, 4G, LTE, Wi-Fi, or any other suitable connection. In some non-limiting embodiments of the present technology, the communication network 50 may be implemented as the Internet. In other embodiments of the present technology, the communication network 50 can be implemented differently, such as any wide-area communication network, local-area communication network, a private communication network and the like.

How the communication links between the user device 200 and the dynamic MLA platform 10 are implemented will depend inter alia on how the user device 200 and the dynamic MLA platform 10 are implemented. Merely as an example and not as a limitation, in those embodiments of the present technology where user device 200 are implemented as wireless communication devices (such as smartphones), the communication link between the user device 200 and the MLA platform 10 can be implemented as a wireless communication link (such as but not limited to, a 3G communication network link, a 4G communication network link, Wireless Fidelity, or WiFi^{®} for short, Bluetooth^{®} and the like). In those examples where one of the user device 200 is implemented as a notebook computer, the corresponding communication link can be either wireless (such as Wireless Fidelity, or WiFi^{®} for short, Bluetooth^{®} or the like) or wired (such as an Ethernet based connection).

The communication network 50 is configured to transmit information and/or computer-readable instructions between the user device 200 and the dynamic MLA platform 10. For example and without limitations, the one or more MLA use request 275 and the corresponding one or more outputs 280 are transmitted over the communication network 50.

### Computing Unit

In response to receiving the MLA execution query 275 comprising indication of, for example, a selection of a desired MLA to be executed and input data for execution of the selected MLA, the orchestrating module 100 may cause execution of the MLA by the computing unit 400. If determination is made by the orchestrating module 100 that the MLA is not already deployed in the MLA-dedicated memory 420, the orchestrating module 100 may deploy the MLA in the MLA-dedicated memory 420. As will be described in greater details herein after, deployment of an MLA in the MLA-dedicated memory 420 may be performed before receiving any MLA execution query 275 requiring execution of said MLA. It can be said that the MLA is "warmed" in the MLA-dedicated memory 420 in anticipation of an execution thereof. In this embodiment, deployment of an MLA before receiving an MLA execution query 275 to do so and/or to execute said MLA is based on an orchestrating model executed by the orchestrating module 100 that is described in greater details herein after.

In this embodiment, the computing unit 400 may be implemented as conventional computer server. In an example of an embodiment of the present technology, each of the computing units 400 may be implemented as a Dell^{™} PowerEdge^{™} Server running the Microsoft^{™} Windows Server^{™} operating system. Needless to say, each of the computing units 400 may be implemented in any other suitable hardware, software, and/or firmware, or a combination thereof. In the depicted non-limiting embodiments of the present technology in FIG. 1, the computing unit 400 is a single server. In alternative non-limiting embodiments of the present technology, the functionality of the computing unit 400 may be distributed and may be implemented via multiple servers.

Those skilled in the art will appreciate that processing unit 410 is generally representative of a processing capability that may be provided by, for example, a Central Processing Unit (CPU). In some embodiments, in place of or in addition to one or more conventional CPUs, one or more specialized processing cores may be provided. For example, one or more Graphic Processing Units 111 (GPUs), Tensor Processing Units (TPUs), accelerated processors (or processing accelerators) and/or any other processing unit suitable for training and executing an MLA may be provided in addition to or in place of one or more CPUs. In this embodiment, the processing unit 410 of the computing unit 400 is a Graphical Processing Unit (GPU) and the MLA-dedicated memory 420 is a Video Random access Memory (VRAM) of the processing unit 410.

Generally speaking, the computing unit 400 is configured to (i) receive instructions and data from the orchestrating module 100 for executing one or more MLAs, (ii) deploy and/or execute, in response to receiving the instructions and data from the orchestrating module 100, the one or more MLAs, (iv) generating one or more corresponding outputs resulting from the execution of the one or more MLAs, and (v) transmitting said outputs to the orchestrating module 100.

Deployment of an MLA in the MLA-dedicated memory 420 may comprise retrieval of said MLA from the MLA database 300. The MLAs may be associated with identifiers in the MLA database 300 to allow an identification thereof, and MLA metadata including information about the corresponding MLA (e.g., a data size of the MLA, a data format of an expected output of the MLA, characteristics of said output, or any other information about the MLA). Before retrieving a given MLA from the MLA database 300, the orchestrating module 100 may assess whether enough data size is available in the MLA-dedicated memory 420 to deploy the given MLA. If determination is made the enough data size is available, the orchestrating module 100 causes deployment of the given MLA onto the MLA-dedicated memory 420. For example, said deployment may include deployment of an inference graph, or « inference engine », of the MLA (e.g. typology of a neural network), and configuring said graph according to pre-determined parameters (e.g. attributing weights to nodes of the neural network). Therefore, deployment of an MLA in the MLA-dedicated memory 420 may be a time-consuming process given relatively large data size of the MLAs. In one aspect, the dynamic MLA platform 10 aims to address this aspect by reducing deployment and execution latency perceived by the user.

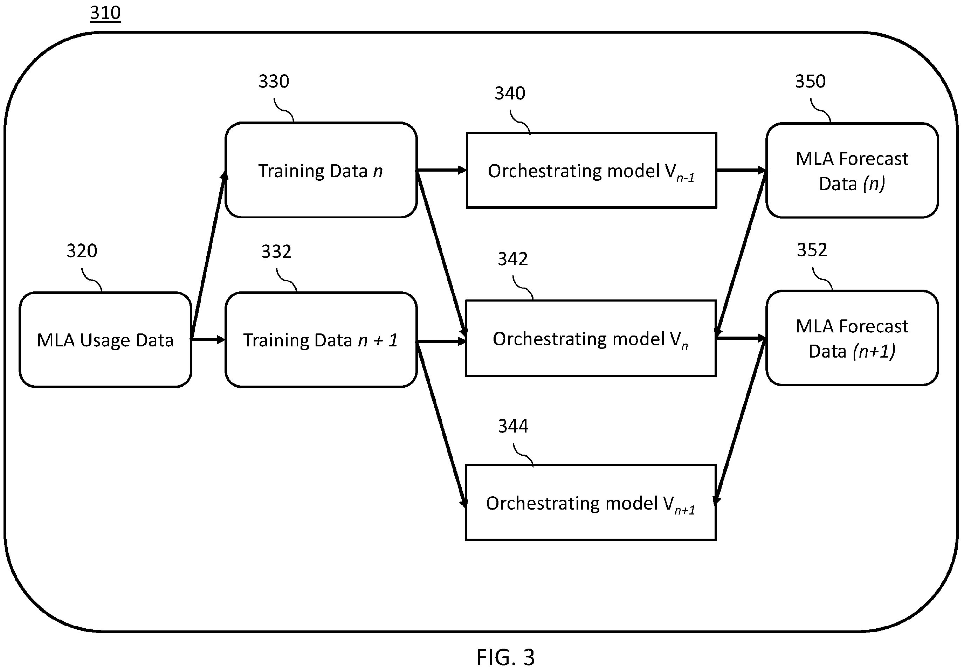

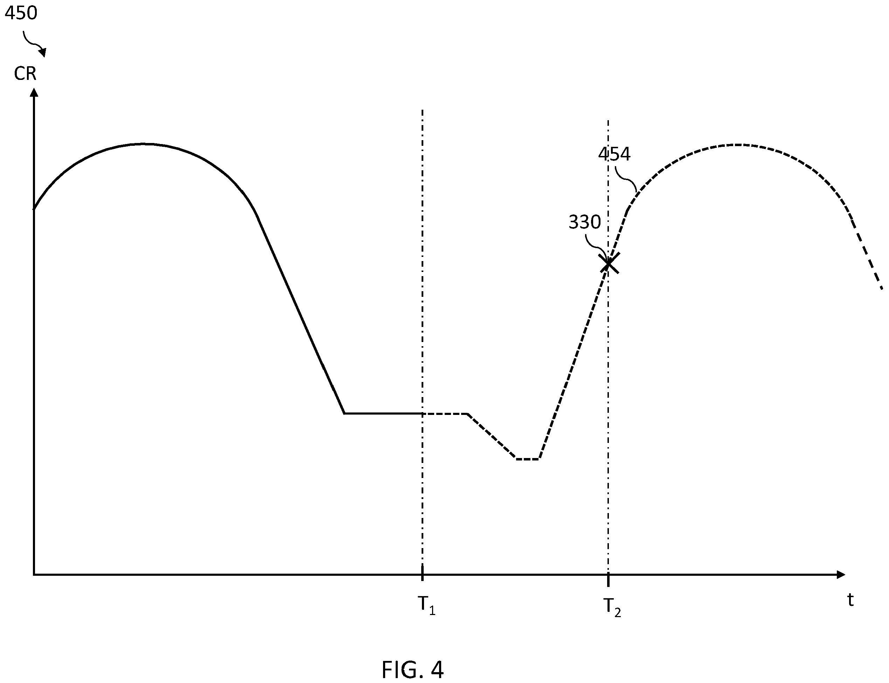

To do so, the orchestrating module 100 orchestrates a memory allocation of the machine learning algorithm (MLA)-dedicated memory 420. Said orchestration relies on generating, updating and executing, by the orchestrating module 100, one or more orchestrating models 340-344. Broadly speaking and with reference to FIGS. 3 and 4, the orchestrating models 340-344 forecast computing resources to be allocated to each MLA based on previous execution of the MLAs and previous MLA execution queries 275 received by the dynamic MLA platform. In some embodiments, the one or more orchestrating models 340-344 may also be configured to forecast correlation, combination, relation and/or dependence of distinct MLAs amongst themselves. As an example, the orchestrating models 340-344 may forecast that a first MLA is to be launched along with a second MLA.

In some embodiments, the forecasted computing resources to be allocated to a given MLA may also be referred to as a "forecasted MLA usage behavior" of the given MLA, as the computing resources to be used to execute said MLA are indicative of a usage of the MLA by the users of the dynamic MLA platform 10. In some embodiments, each of the orchestrating models 340-344 may be, for example and without limitation, be implemented as a knowledge-based system comprising one or more set of rules modeling forecasted MLA usage behaviors which may equally be broadly referred to as an expert system. In some other embodiments, the orchestrating models may be implemented using statistical predictive and/or machine-learning approaches based on algorithms such as, but non-limited to, non-linear algorithm, linear regression, logistic regression, support vector machine, random forest, neural network, gradient boosting, adaboost, lasso, elastic net, ridge, Stochastic Gradient Descent (SGD) regressor and/or Support Vector Regression (SVR).

FIG. 3 illustrates training iterations 310 of orchestrating models 340-344. More specifically, the orchestrating model 340 is a first version (noted "Vₙ₋₁") of the orchestrating model before a first training iteration. In order to simply a description of the training iteration, the following description is oriented to the creation of the orchestrating model 340 to determine the forecasted MLA usage behavior of a given MLA. It should be understood that the following description can be applied to the training of the orchestrating model 340 to determine the forecasted MLA usage behaviors of a plurality of MLAs simultaneously, including the combination, relation and/or dependence of distinct MLAs at a given time and/or over time.

To generate the orchestrating model 342, a training dataset n 330 is used as an input. In this embodiment, the training dataset *n* 330 includes:
- information about number of MLA execution queries 275 for the given MLA, said number being associated with a temporal indication (e.g., a date, a time and/or a period of time);
- information about execution runtimes of the given MLA, the execution runtimes being indicative of processing times during which a given MLA has been executed to generate corresponding outputs 280, said number being associated with a temporal indication (e.g. a date, a time and/or a period of time);
- information about computing resources of the dynamic MLA platform 10 used for deployment and during execution of the given MLA; and/or
- dependence of the given MLA with other MLAs at a given time and/or over time

As such, the training dataset *n* 330 for a given MLA is representative of an expected computer resources required to execute the MLA at a given moment later in time. Embodiments wherein the training dataset n 330 includes information about additional operating parameters of the dynamic MLA platform 10 for executing the given MLA are also contemplated.

In the illustrated embodiment of FIG. 3, the training dataset *n* 330 is used to create orchestrating model 342. As previously explained, the orchestrating model 342 may take the form of a set of rules which are determined based on an analysis of the training dataset n 330. Once generated, the orchestrating model 342 may be relied upon to generate the MLA forecast data (*n*+*1*) 352 representative of an expected amount of computer resources required to execute the MLA at a moment later in time. In other embodiments, the MLA forecast data (*n*) 350 may model other information relevant to the execution of the MLA such as, but not limited to, the MLA relation with other MLAs (for example, so as to model that a first MLA is to be operated along with a second MLA). As it may be appreciated from the reading of FIG. 3, the training data (*n*+*1*) 332 and/or the MLA forecast data (*n*+*1*) may be also used to generate another iteration of the orchestrating model 342 also referred to as the orchestrating model 344. The same also applies with respect to the training data (*n*+*1*) 332 and/or the MLA forecast data (*n*+*1*) which may be relied upon to generate yet another iteration of the orchestrating model 340 also referred to as the orchestrating model 344. As the person skilled in the art may appreciate, this iterative approach allows continuous improvement of the orchestrating model by generating updated orchestrating model as more training data and/or MLA forecast data becomes available. In some embodiments, a function, which may be referred to as a performance indicator, is configured to assess the accuracy of the orchestrating model by comparing its associated MLA forecast data with actual data collected from the operating of the MLAs thereby reconciliating predictions with real-life information. Such function allows assessment and ranking of orchestrating models so as to prioritize usage of orchestrating models that are most accurate given certain operation conditions. In some embodiments, the function may be configured to assess the hardware resources that have been saved by a given orchestrating model. In some embodiments, the function may also be referred to as a performance indicator.

Turning now to FIG. 4, a temporal evolution 450 of computer resources used for execution of a given MLA within the dynamic MLA platform 10 is illustrated. At a current time t=T₁, the orchestrating module 100 may use the orchestrating model 342 to determine a forecasted MLA usage behavior 454 (dashed portion of the graph). More specifically, the forecasted MLA usage behavior 454 is, in this embodiment, determined based on concatenation of MLA forecast data, such as MLA forecast data 352. For example, the orchestrating model 342 may generate, at t=T₁ and based on the temporal evolution 450 for t< T₁, the MLA forecast data 352 indicative of excepted computer resources for executing the MLA at a later moment in time at t=T₂.

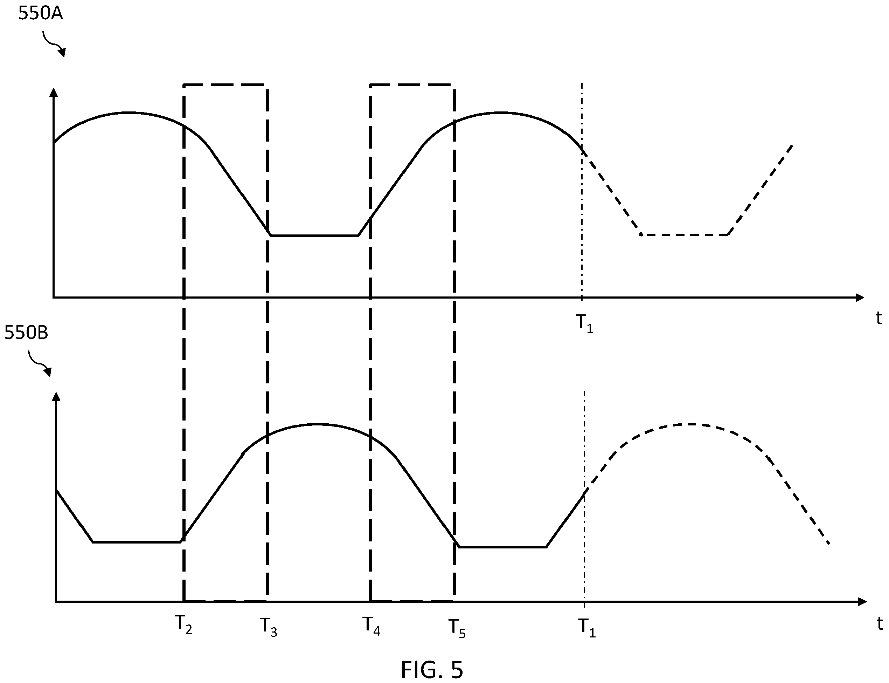

FIG. 5 is a temporal evolution 550A of computing resources used for execution of a first MLA in the MLA-dedicated memory 420, and a temporal evolution 550B of computing resources used for execution of a second MLA in the MLA-dedicated memory 420. In this illustrative example, the first and second MLA are two opposite textual translation models. For instance, the first MLA may be a French-to-English translation model that receives a text in French as input data, and output a translation of said text in English, and the second MLA may be an English-to-French translation model that receives a text in English as input data, and output a translation of said text in French.

A first portion of the temporal evolutions 550A, 550B for t<T₁ depicts recorded MLA usage of the first and second MLA respectively. The portions in dashed lines of the temporal evolutions 550A, 550B for t>T₁ represent forecasted MLA usage behavior determined by the orchestrating model 342 based on the orchestrating model 342. In this illustrative example, it can be said that, for T₂<t<T₃, the first MLA is progressively unloaded from the MLA-dedicated memory 420 to let the second MLA progressively grow in the MLA-dedicated memory 420. This mirrored MLA usage behavior may result from the time difference between France and the USA and Canada. Indeed, for T₂<t<T₃, less and less user in France are likely to use the first MLA for French-to-English translation during nighttime in France, while more and more users in the USA and/or Canada are likely to use the second MLA for English-to-French translation as the day in that location starts.

In some embodiments, the MLA forecast data for a given MLA (e.g. the first MLA) may be further used to determine MLA usage behavior of another MLA (e.g. the second MLA). Indeed, a plurality of MLA may form a group of MLAs sharing MLA forecast data. For example, if a correlation exists between a first MLA and a second MLA, the first MLA may have a first corresponding forecasted MLA usage behavior, and the second MLA may have a second forecasted MLA usage behavior that is determined, at least partially, based on the first forecasted MLA usage behavior of the first MLA. Any function (e.g. an offset function) may be applied to the first forecasted MLA usage behavior of the first MLA to determine the second forecasted MLA usage behavior of the second MLA. The second forecasted MLA usage behavior of the second MLA may be further adjusted based on MLA forecast data specific to the second MLA.

The computing resources may be partitioned into a plurality of resource pools. For example, a given resource pool may correspond to 1Giga Octet (Go) of the MLA-dedicated memory 420. The partitioning may be performed by the orchestrating module 100. As such, the orchestrating module 100 may allocate and adjust a number of resource pools for the deployment and execution of a given MLA. The number of resource pools used for the deployment and execution of a given MLA corresponds to the computing resources required for said MLA.

In at least some embodiments, the dynamic MLA platform 10 may be a Kubernetes-based platform. In other words, the dynamic MLA platform 10 may support a Kubernetes cluster architecture such that MLA are part of containerized applications (or "containers"). The containers may be distributed and managed by the orchestrating module 100 that may be referred, in the context of the Kubernetes-based platform, as a "control plane". In this context, the computing units 400 may thus be referred as "nodes" of the Kubernetes-based platform. Furthermore, still in the context of the Kubernetes-based platform, the resource pools may be referred as a "pods". For instance, the orchestrating module 100 may be relied upon to dynamically allocate resources based on current and/or anticipated usage of the MLA of the MLA database 300. Such resource allocation may involve, without being limitative, increasing a network capacity and/or a processing capacity (e.g., via the creation and/or control over virtual machines operated by the computing devices).

With reference to FIG. 5, a number of users of the first MLA may decrease for T₂<t<T₃, which causes the orchestrating module 100 to progressively decrease a number of resource pools dedicated for executing the first MLA. The same reasoning applies for the second MLA for T₄<t<T₅. However, for T₂<t<T₃, a number of users transmitting MLA execution queries for execution of the second MLA increases, causing the orchestrating module 100 to progressively increase a number of resource pools dedicated for executing the second MLA. As such, the first MLA may be discarded (or "unloaded") from some resource pools such that those resources pools may be dedicated for the deployment and execution of the second MLA.

Developers of the present technology have devised MLA categories to further optimize a warming of some MLAs in the MLA-dedicated memory 420. In some embodiments, each MLA is associated with an MLA category, each MLA category having a corresponding Time-to-Live (TTL). More specifically, MLA categories may be indicative of discarding instructions to be executed to discard or not to discard the given MLA from the MLA-dedicated memory 420. In the context of the present disclosure, a TTL is a value of a period of time during which the corresponding MLA should stay deployed on a given resource pool without being discarded after having been executed. Moreover, in one embodiment, each MLA is associated with a corresponding level of priority regardless of the MLA category. In some embodiments, the MLA of a same MLA category have a same level of priority. The following table illustrates the different MLA category contemplated in this embodiment:

| **MLA category** | **Time-to-Live (TTL)** |
|---|---|
| Persistent | ∞ |
| Preemptible | 0<TTL<∞ |
| Highly preemptible | 0 |
| Ephemeral | <0 |

More specifically, once a persistent MLA has been deployed, and executed, the persistent MLA is not discarded from the MLA-dedicated memory 420 regardless of execution conditions.

Once a preemptible MLA has been deployed and executed, the orchestrating module 100 triggers a counter indicative of an amount of time that has passed since the execution of the given MLA has ended. In response to the counter reaching the TTL (for example 20 minutes) without the MLA being executed, the MLA may be discarded from the MLA-dedicated memory 420. In this embodiment, the preemptible MLA is discarded in response to:
- the counter having reached the TTL; and
- an MLA having a same level of priority or a higher level of priority is to be deployed in the MLA-dedicated memory 420.

As such, if no MLA having a same level of priority or a higher level of priority is to be deployed in the MLA-dedicated memory 420, the preemptible MLA may be kept deployed in the MLA-dedicated memory 420. The counter is reset in response to the given preemptible MLA being further executed before the counter having reached the TTL. For example, a new MLA execution queries 275 may be received by the dynamic MLA platform 10 causing new execution of the given preemptible MLA. The counter is further triggered again in response to the new execution being ended.

Highly preemptible MLAs are preemptible MLA for which the TTL is zero (0). As such, once the execution of the highly preemptible MLA ends, the highly preemptible MLA is discarded in response to an MLA having a same level of priority or a higher level of priority is to be deployed in the MLA-dedicated memory 420.

Ephemeral MLAs are automatically discarded from the MLA-dedicated memory 420 once an execution thereof has ended.

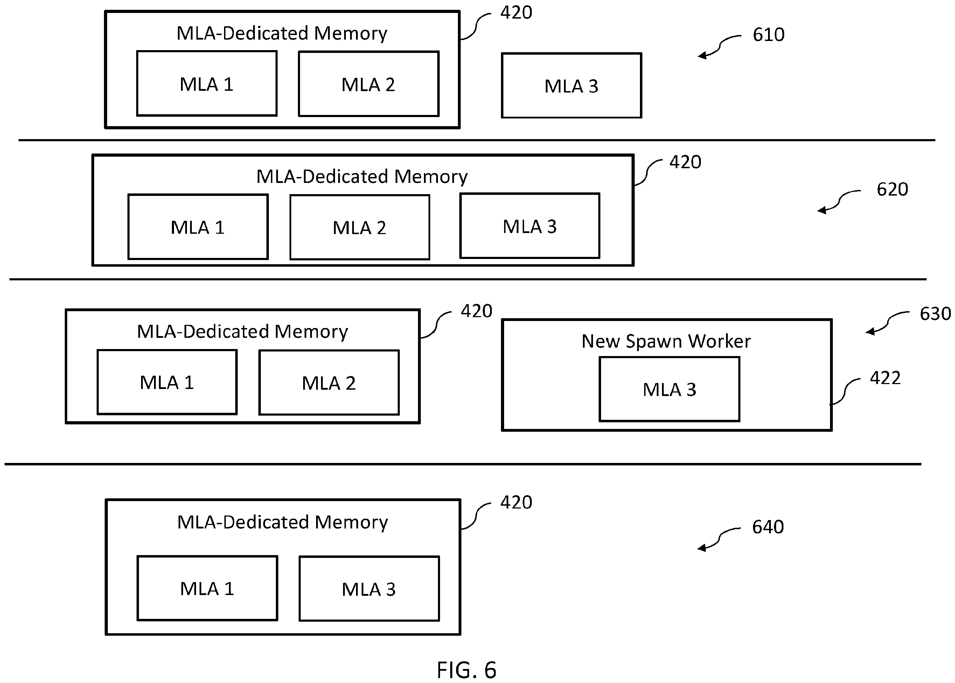

To better illustrates the use of the MLAs categories, FIG. 6 illustrates a plurality of configurations of the MLA-dedicated memory 420 in different use case scenarios. Representation 610 represents a content of the MLA-dedicated memory 420 where a first MLA (noted "MLA1") and a second MLA (noted "MLA2") are deployed. The following scenarios are directed to use cases where a third MLA (noted "MLA3") is to be deployed in the MLA-dedicated memory 420, MLA 3 having a same level of priority that at MLA2 or above. For example, the dynamic MLA platform 10 may receive an MLA execution query comprising indication that the MLA 3 is to be executed. As such, given that the MLA3 is not yet deployed in the MLA-dedicated memory 420, the orchestrating module has to deploy the MLA 3 in the MLA-dedicated memory 420.

### Scenario 1

In a first scenario, a data size of the MLA 3 is below a remaining memory space of the MLA-dedicated memory 420. In other words, there is enough computing resources in the MLA-dedicated memory 420 to deploy the MLA3. Representation 620 depicts the content of the MLA-dedicated memory 420 in the first scenario, where MLA1, MLA2 and MLA3 are deployed onto the MLA-dedicated memory 420.

### Scenario 2

The following scenario described a use case where the remaining memory space of the MLA-dedicated memory 420 is below a data size of the MLA3.

In the second scenario, MLA1 is a persistent MLA and MLA2 is a preemptible MLA with a given TTL or a highly preemptible MLA with a TTL equal to zero. The counter associated with MLA2 is referred to as "t". It is assumed that no call to MLA2 is received after the counter being triggered (i.e. no MLA execution query directed to MLA2 is received by the dynamic MLA platform).

If *t* is below TTL, MLA2 cannot be discarded from the MLA-dedicated memory 420, and MLA3 thus cannot be deployed in the MLA-dedicated memory 420. A new computing unit thus has to be spawned to deploy and execute MLA3. For example, said new computing unit may be a new spawn GPU worker. Representation 630 depicts the content of the MLA-dedicated memory 420 in the second scenario for t<TTL, where MLA1 and MLA2 are deployed onto the MLA-dedicated memory 420 and MLA3 is deployed onto a new spawn worker 422.

If *t* is above TTL, MLA2 can be discarded. MLA 2 is thus discarded to let MLA3 be deployed in the MLA-dedicated memory 420. As a result, there is no need for anew computing unit to be spawned, which saves time and computing resources. Representation 640 depicts the content of the MLA-dedicated memory 420 in the second scenario for t>TTL, where MLA1 and MLA3 are deployed onto the MLA-dedicated memory 420, MLA2 having been discarded from the MLA-dedicated memory 420.

As the person skilled in the art would readily understand, the described scenarios are valid regardless of an MLA category of MLA3. The described scenarios are also valid for MLA2 being an ephemeral MLA, given that MLA2 would be discarded as soon as an execution thereof has ended. The described scenarios are also valid for any use cases where MLA1 is a preemptible MLA with a corresponding TTL above the TTL of MLA2. If the TTL ofMLA1 is below the TTL of MLA2, the roles of MLA1 and MLA2 in the afore described scenarios would be inverted.

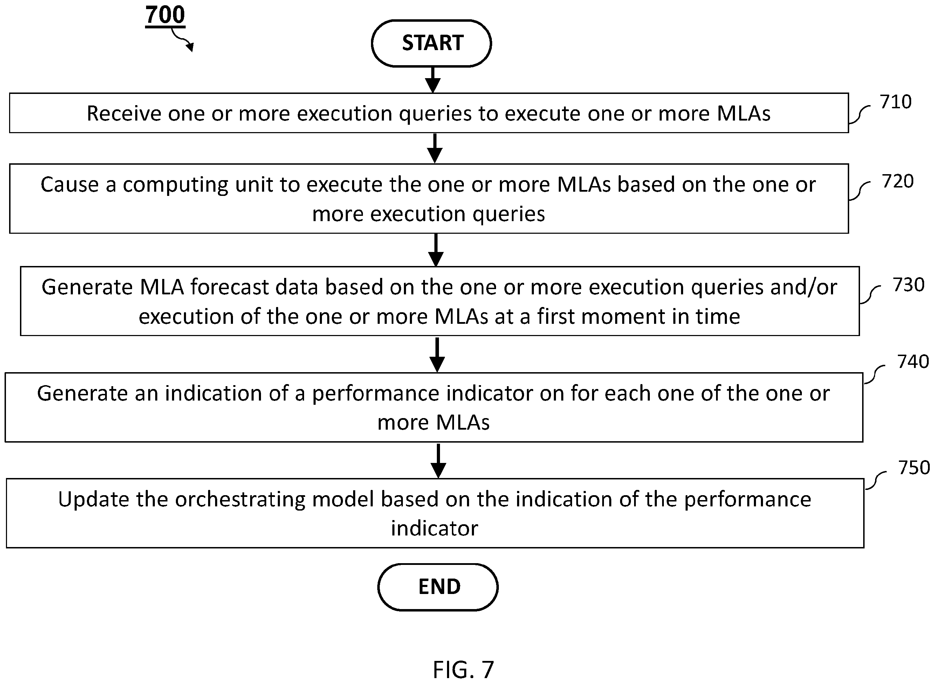

FIG. 7 is a flow diagram of a method 700 for generating an orchestrating model configured to orchestrate a memory allocation of an MLA-dedicated memory communicably connected to a computing unit, the computing unit being configured to execute one or more MLAs deployed in the MLA-dedicated memory, the computing unit being communicably connected to an MLA database configured for storing a plurality of MLAs, according to some embodiments of the present technology. In one or more aspects, the method 700 or one or more steps thereof may be performed by a processor or a computer system, such as the orchestrating module 100. The method 700 or one or more steps thereof may be embodied in computer-executable instructions that are stored in a computer-readable medium, such as anon-transitory mass storage device, loaded into memory and executed by a CPU/GPU/TSU. Some steps or portions of steps in the flow diagram may be omitted or changed in order.

The method 700 includes, at step 710, receiving one or more execution queries to execute the one or more MLAs. For example, the orchestrating module 100 may receive MLA execution queries 275 indicative of users' desires to execute the one or more MLAs. In this embodiment, the orchestrating module 100 receives the MLA execution queries 275 from the user devices 200 over the communication network 50 and through the communication application 20. In some embodiments, the communication application 20 is operated as an Application Programming Interface (API) gateway. The user of the user devices 200 may be provided with a choice of MLAs included in the MLA database 300 that may be executed by the dynamic MLA platform 10. Said choice may be, for example and without limitations, visually rendered under the form of a carousel and/or a catalogue on a screen or any display device of the user device 200. The user may further select one or more MLAs to be executed and upload corresponding input data to the dynamic MLA platform 10, thereby forming one or more MLA execution request. Metadata of the one or more MLA execution queries may concurrently be generated and accessed by the orchestrating module 100 such as temporal indications associated with the MLA execution queries.

The method 700 includes, at step 720, causing a computing unit, such as the computing unit 400, to execute the one or more MLAs based on the one or more execution queries. In response to determining that a given MLA to be executed is not deployed onto the MLA-dedicated memory 420, the orchestrating module 100 may deploy said MLA from the MLA database 300 onto the MLA-dedicated memory 420. In this embodiment, computing resources of the computing unit 400 may be partitioned into a plurality of resource pools such as a given resource pool may be used for execution of a single MLA at a time. This increase privacy of execution of the MLAs by the dynamic MLA platform 10. The orchestrating module 100 may adjust a number of computing resources allocated to a same MLA based on the MLA execution queries. For example, the orchestrating module 100 may increase a number of computing resources allocated to a given MLA in response to receiving an increased number of MLA execution queries directed to execution of the given MLA. Additionally or optionally, the orchestrating module 100 may adjust a number of computing resources allocated to a same MLA based on information comprised in the MLA execution queries. For example, if determination is made that a given MLA execution query comprises a relatively high amount of data input to be inputted in a given MLA, the orchestrating module 100 may adjust a number of computing resources allocated to the given MLA accordingly (e.g. increasing a number of computing resources allocated to the given MLA in this example).

In this embodiment, the MLAs are associated with MLAs categories described above. For each MLA deployed and executed onto the MLA-dedicated memory 420, the orchestrating module 100 determines an end of the execution. For ephemeral MLA, the orchestrating module 100 discards, or "unload", the ephemeral MLA. For preemptible MLAs, the orchestrating module 100 triggers a counter associated with a corresponding and pre-determined TTL. In response to no new execution of the preemptible MLA being caused by reception of an MLA execution query until the counter reaches the TTL, the orchestrating module 100 may discard the preemptible MLA from the MLA-dedicated memory 420. The preemptible MLA is effectively discarded from the MLA-dedicated memory 420 in response to an MLA having a same or high level of priority being to be deployed in the MLA-dedicated memory 420. In one embodiment, all the MLAs of the MLA database 300 have a same level of priority.

For highly preemptible MLAs, the same reasoning applies with a TTL set to zero. For persistent MLAs, the same reasoning applies with a TTL set to infinity (i.e. a persistent MLA is maintained in the MLA-dedicated memory 420 once deployed).

The method 700 includes, at step 730, generating MLA forecast data based on the one or more execution queries and/or execution of the one or more MLAs at a first moment in time. MLA forecast data associated with a given MLA are indicative of forecasted computing resources required to execute said given MLA at a time in the future. Based on MLA forecast data, the orchestrating module 100 may determine a forecast MLA usage behavior of the MLA as illustrated in FIGS. 4 and 5.

In this embodiment, the MLA forecast data for a given MLA are based on a number of MLA execution request direct to said MLA, temporal indications associated with said MLA execution queries (a time at which the queries are emitted by the user devices 200 and/or at which they are received by the orchestrating module 100), a content thereof, and current and past executions of the given MLA. For example, if determination is made that, every Monday at 9:00, execution of a given MLA is required by a certain amount of MLA execution queries with a global amount of input data of all of the MLA execution queries, the orchestrating module 100 may generate a corresponding MLA forecast data for that MLA indicating that said MLA is expected to be deployed and executed at 9:00 every next Monday according to said global amount of input data. It can thus be also said that MLA forecast data are based temporal indication of a desired execution of the corresponding MLA. As such, in some embodiments, MLA forecast data of a given MLA is also based on the aforementioned metadata of the MLA execution queries, or "execution query metadata", including information about computing resources required to execute the given MLA. For example, said computing resources may be determined based on the global input data received by the dynamic MLA platform 10. Indeed, a relatively high amount of input data received from a plurality of user devices 200 may require a high amount of computing resources to execute the MLA. As such, MLA forecast data may depend on an amount of input data received in the MLA execution queries, said amount being considered as execution query metadata.

MLA forecast data of a given MLA is also based on an evolution of the number of resource pools required to execute the given MLA, as depicted by the temporal evolutions 550A, 550B on FIG. 5. In some embodiments, MLA forecast data of a given MLA is also based on execution runtimes of the executions of the MLA.

The method 700 includes, at step 740, generating an indication of a performance indicator for each one of the one or more MLAs, the indication having been computed based on a comparison of the MLA forecast data of the MLA and execution queries for the MLA and/or current execution of the one or more MLAs at a second moment in time, the second moment in time being later than the first moment in time. The performance indicator is indicative of a difference between the expected computer resources for executing the one or more MLAs given their MLA category, and current computer resources for said execution.

The method 700 includes, at step 750, updating, based on the indication of the performance indicator, the orchestrating model 342. A training iteration is described with respect to FIG. 3.

In some embodiments, the method 700 further comprises executing the updated orchestrating model 342. In use, the updated orchestrating model 342 deploys MLAs from the MLA database onto the MLA-dedicated memory based on the MLA forecast data corresponding to said MLAs and prior to receiving one or more execution queries for executing said MLAs in order to warm the MLA-dedicated memory 420 with deployment of the MLAs. As described above, the MLA forecast data of a given MLA may form a forecasted MLA usage behavior thereof.

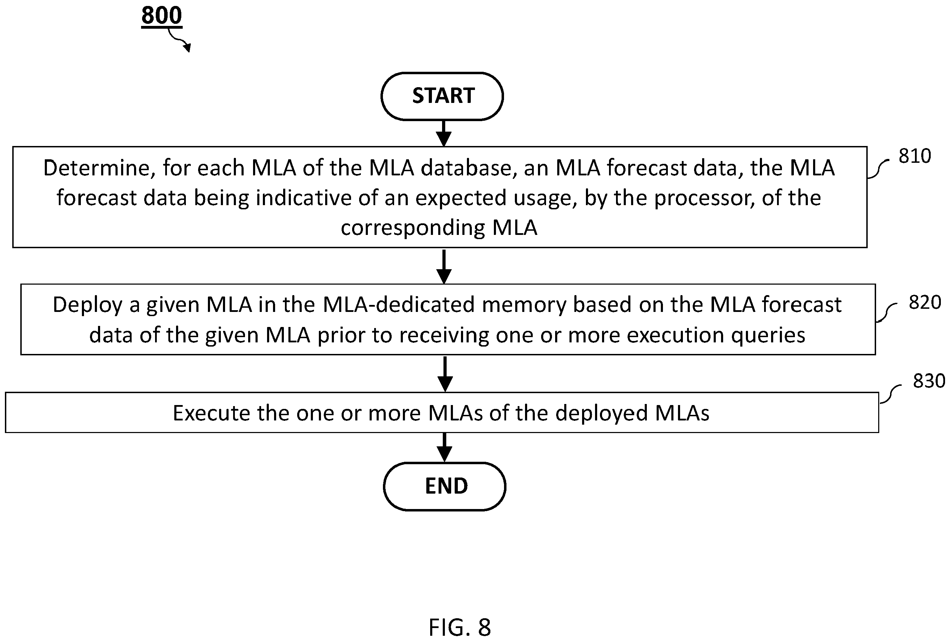

FIG. 8 is a flow diagram of a method 800 for orchestrating a memory allocation of a machine learning algorithm (MLA)-dedicated memory communicably connected to a computing unit, the computing unit being configured to execute MLAs deployed in the MLA-dedicated memory, the MLA-dedicated memory being communicably connected to a MLA database configured for storing a plurality of MLAs, according to some embodiments of the present technology.

In one or more aspects, the method 800 or one or more steps thereof may be performed by a processor or a computer system, such as the orchestrating module 100. The method 800 or one or more steps thereof may be embodied in computer-executable instructions that are stored in a computer-readable medium, such as a non-transitory mass storage device, loaded into memory and executed by a CPU. Some steps or portions of steps in the flow diagram may be omitted or changed in order.

The method 800 includes, at step 810, determining, for each MLA of the MLA database, an MLA forecast data, the MLA forecast data being indicative of an expected usage, by the computing unit, of the corresponding MLA. In this embodiment, the MLA forecast data and, more generally, the forecasted MLA usage behavior, of each MLA is determined by the trained orchestrating model 342 generated and trained based on the method 700.

The method 800 includes, at step 820, deploying a given MLA in the MLA-dedicated memory based on the MLA forecast data of the given MLA prior to receiving one or more execution queries. In the embodiment, the orchestrating model 342 deploys the MLAs based on the forecasted MLA usage behavior of each MLA. For example, if determination is made that, based on the forecasted MLA usage behavior of a given MLA, a certain number of users will desire to execute the given MLA at a given time, the orchestrating module 100 deploys the given MLA in the MLA-dedicated memory 420 such that it can be executed with an expected amount of computing resources at said given time. In other words, the orchestrating module 100 deploys the MLA "in advance" according to its forecasted MLA usage behavior.

The method 800 includes, at step 830, executing the one or more MLAs of the deployed MLAs. In use, execution of a given MLA is effectively initiated in response to receiving an MLA execution query for that MLA. In some embodiments, the orchestrating model 342 is continuously trained, such that step 830 may further comprise generating further MLA forecast data, the further generated MLA forecast data being relied upon to further train the orchestrating model 342.

The users of the dynamic MLA platform 10 thus perceive a reduced execution latency given that the MLAs are already deployed in the MLA-dedicated memory 420, said deployed MLAs being expected to be executed based on forecasted MLA usage behavior determined by the trained orchestrating model 342.

While the above-described implementations have been described and shown with reference to particular steps performed in a particular order, it will be understood that these steps may be combined, sub-divided, or re-ordered without departing from the teachings of the present technology. At least some of the steps may be executed in parallel or in series. Accordingly, the order and grouping of the steps is not a limitation of the present technology.

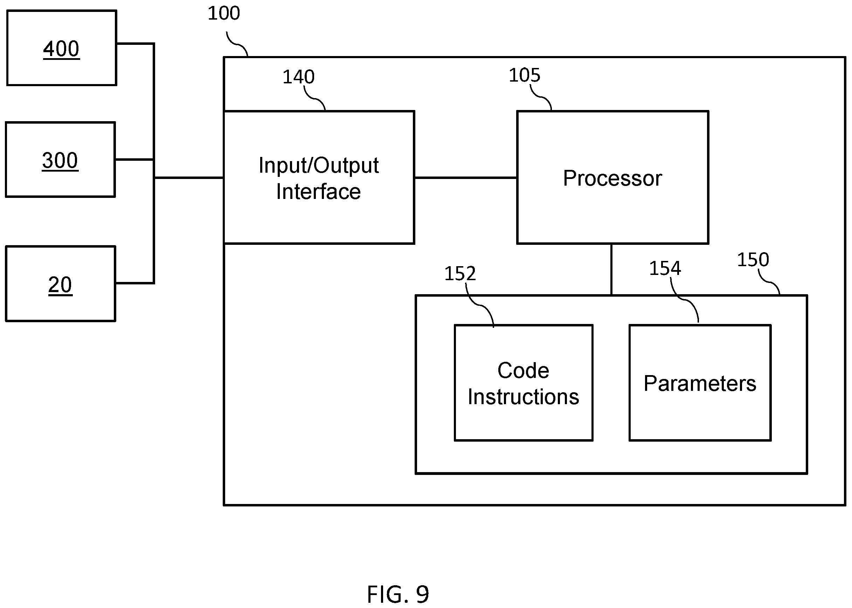

FIG. 9 is an example of a schematic block diagram of the orchestrating module 100 implemented as a controller of the dynamic MLA platform 10 according to an embodiment of the present technology. In some embodiment, all the functions or a portion thereof of the orchestrating module 100 may be performed by a controller of the computing unit 400 (e.g. the processing unit 410). The orchestrating model 100 comprises a processor or a plurality of cooperating processors (represented as a processor 105 for simplicity), a memory device or a plurality of memory devices (represented as a memory device 150 for simplicity), and an input/output interface 140 allowing the orchestrating model 100 to communicate with other components of the dynamic MLA platform 10 and/or other components in remote communication with the dynamic MLA platform 10. The processor 105 is operatively connected to the memory device 150 and to the input/output interface 140. The memory device 150 includes a storage for storing parameters 154, including for example and without limitation parameters for deployment of the MLAs from the MLA database 300 onto the MLA-dedicated memory 420. The memory device 150 may comprise a non-transitory computer-readable medium for storing code instructions 152 that are executable by the processor 105 to allow the orchestrating model 100 to perform the various tasks allocated to the orchestrating model 100 in the methods 700, 800.

The orchestrating model 100 is operatively connected, via the input/output interface 140, to the computing unit 400, the MLA database 300 and the communication application 20. The controller 700 executes the code instructions 152 stored in the memory device 150 to implement the various above-described functions that may be present in a particular embodiment. FIG. 9 as illustrated represents a non-limiting embodiment in which the orchestrating model 100 orchestrates operations of the dynamic MLA platform 10. This particular embodiment is not meant to limit the present disclosure and is provided for illustration purposes.

It should be expressly understood that not all technical effects mentioned herein need to be enjoyed in each and every embodiment of the present technology.

Modifications and improvements to the above-described implementations of the present technology may become apparent to those skilled in the art. The foregoing description is intended to be exemplary rather than limiting. The scope of the present technology is therefore intended to be limited solely by the scope of the appended claims.

## Claims

1. A method for generating an orchestrating model configured to orchestrate a memory allocation of a machine learning algorithm (MLA)-dedicated memory communicably connected to a computing unit, the computing unit being configured to execute one or more MLAs deployed in the MLA-dedicated memory, the computing unit being communicably connected to an MLA database configured for storing a plurality of MLAs, the method comprising:
receiving one or more execution queries to execute the one or more MLAs;
causing the computing unit to execute the one or more MLAs based on the one or more execution queries;
generating MLA forecast data based on the one or more execution queries and/or execution of the one or more MLAs at a first moment in time;
generating an indication of a performance indicator for each one of the one or more MLAs, the indication having been computed based on a comparison of the MLA forecast data of the MLA and execution queries for the MLA and/or current execution of the one or more MLAs at a second moment in time, the second moment in time being later than the first moment in time; and
updating the orchestrating model based on the indication of the performance indicator.

2. The method of claim 1, further comprising, subsequent to causing the computing unit to execute a given MLA:
detecting an end of the execution of the given MLA.

3. The method of claim 2, further comprising, subsequent to detecting the end of the execution of the given MLA:
discarding the given MLA from the MLA-dedicated memory.

4. The method of claim 3, wherein the given MLA is associated with an MLA category in the MLA database, the MLA category being indicative of discarding instructions to be executed to discard the given MLA from the MLA-dedicated memory.

5. The method of claim 4, wherein the discarding instructions comprise indication of a pre-determined time duration, the method further comprising, subsequent to detecting the end of the execution of the given MLA:
triggering a counter indicative of an amount of time that has passed since the end of the execution of the given MLA has been detected, and wherein
discarding, the given MLA from the MLA-dedicated memory comprises:
in response to the counter reaching the pre-determined time value, discarding the given MLA from the MLA-dedicated memory.

6. The method of claim 5, wherein the given MLA is a first MLA, the MLA category being further indicative of a priority level of the first MLA, and
wherein discarding the given MLA from the MLA-dedicated memory is made in response to determining that a second MLA is to be deployed in the MLA-dedicated memory, the second MLA having a priority level than a priority level of the first MLA.

7. The method of claims 5 or 6, wherein:
a first MLA category is indicative of instructions comprising indication of a first pre-determined time duration, the first pre-determined duration being strictly positive; and
a second MLA category is indicative of instructions comprising indication of a second pre-determined time duration, the second pre-determined duration being zero.

8. The method of claim 1, wherein:
each MLA of the MLA database is associated with an MLA category and a level priority, the MLA category being indicative of discarding instructions to be executed subsequent to an execution thereof;
a first MLA category is associated with discarding instructions which, upon being executed, cause an MLA of the first MLA category to be maintained in the MLA-dedicated memory;
a second MLA category is associated with discarding instructions which, upon being executed, cause an MLA of the second MLA category to be discarded from the MLA-dedicated memory once an execution thereof has ended;
a third MLA category is associated with discarding instructions which, upon being executed, cause:
a timer to be triggered once an execution of an MLA of the third MLA category has ended, the timer having a pre-determined value for each MLA of the third category, the timer being reset in response to the MLA being further executed and further triggered once the new execution has ended, and
the MLA of the third MLA category to be discarded from the MLA-dedicated memory once the timer has reached the pre-determined value and in response to an MLA having a higher priority level is to be deployed in the MLA-dedicated memory; and
a fourth MLA category is associated with discarding instructions which, upon being executed, cause an MLA of the fourth MLA category to be discarded from the MLA-dedicated memory in response to an MLA having a higher priority level is to be deployed in the MLA-dedicated memory.

9. The method of any one of claims 1 to 8, further comprising:
partitioning computer resources of the computing unit into a plurality of resource pools;
extracting, from the one or more execution queries, information about a number of resource pools required to execute the one or more corresponding MLAs.

10. The method of any one of claims 1 to 9, wherein:
causing the computing unit to execute the one or more MLAs based on the one or more execution queries comprises determining an execution runtime of each of the one or more MLAs;
receiving one or more execution queries to execute the one or more MLAs comprises determining, for each MLA, a temporal indication of a desired execution of the MLA; and
MLA forecast data associated with a given MLA is based at least in part on the execution runtime of the given MLA and at least in part on the determined temporal indication.

11. The method of any one of claims 1 to 10, further comprising:
determining, for each MLA of the MLA database, an MLA forecast data indicative of an expected usage, by the computing unit, of the corresponding MLA; and
using the MLA forecast data to generate the orchestrating model.

12. The method of any one of claims 1 to 11, wherein each MLA is associated with an MLA category, the MLA category being indicative of instructions to be executed by a controller to discard a given MLA.

13. The method of claim 12, wherein the instructions comprise indication of a pre-determined time duration, the method further comprising:
detecting an end of the execution of the given MLA:
triggering, by the controller, a counter indicative of an amount of time that has passed since the end of the execution of the given MLA has been detected; and
in response to the counter reaching the pre-determined time value, discarding, by the controller, the given MLA from the MLA-dedicated memory.

14. A system for orchestrating a memory allocation of a machine learning algorithm (MLA)-dedicated memory communicably connected to a processor, the processor being configured to execute MLAs deployed in the MLA-dedicated memory, the system comprising a controller and a memory storing a plurality of executable instructions which, when executed by the controller, cause the system to perform the method of any one of claims 1 to 13.

15. A non-transitory computer-readable medium comprising computer-readable instructions that, upon being executed by a system, cause the system to perform the method of any one of claims 1 to 13.
